# EUROPEAN PATENT APPLICATION

(11) **EP 4 804 736 A1**
(43) Date of publication of application: **09.09.2026**
(21) Application number: 25161951.6
(22) Date of filing: 05.03.2025
(51) Int. Cl.: H05K 1/18, H05K 3/46, H05K 3/28, H05K 1/02

(54) **COMPONENT CARRIER AND METHOD FOR MANUFACTURING A COMPONENT CARRIER**

(71) Applicant: AT & S Austria Technologie & Systemtechnik Aktiengesellschaft, 8700 Leoben (AT)
(72) Inventor: ZLUC, Andreas, 8700 Leoben (AT); HERK-PICKL, Johannes, 8732 Seckau (AT)
(74) Representative: Donatello, Daniele

(57) **Abstract**

The present invention relates to a component carrier (100) a method for manufacturing thereof, wherein the component carrier (100) comprises a stack (110) comprising at least one electrically conductive layer structure (104) and a plurality electrically insulating layer structures (102), said stack (110) comprising a cavity (130). A component (140) is embedded in the cavity (130) and at least one further layer portion (120) is partially filling the cavity (130). The space between the cavity (130) and component (140) and/or the at least one further layer portion (120) is filled by resin (150) flowed from one of the plurality of electrically insulating layer structures and/or from the at least one further layer portion.

## Description

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

For example, embedding a component into a cavity and reliably fully filling the cavity with resin, may be challenging.

There may be a need to create a component carrier comprising a cavity, embedding a component in the cavity and at least one further layer portion partially filling the cavity, in an efficient, reliable, and robust manner.

In order to achieve the object defined above, a component carrier and a method of manufacturing the component carrier according to the independent claims are provided. The dependent claims describe advantageous embodiments.

### Field of the Invention

The present invention generally relates to a component carrier comprising a stack comprising at least one electrically conductive layer structure and a plurality electrically insulating layer structures, said stack comprising a cavity. A component is embedded in the cavity and at least one further layer portion is partially filling the cavity. The space between the cavity and component and/or the at least one further layer portion is filled by resin flowed from one of the plurality of electrically insulating layer structures and/or from the at least one further layer portion.

Further, the present invention relates to a method for manufacturing a component carrier as described.

According to a first aspect of the present invention, a component carrier is provided, wherein the component carrier comprises a stack comprising at least one electrically conductive layer structure and a plurality electrically insulating layer structures, said stack comprising a cavity. A component is embedded in the cavity and at least one further layer portion is partially filling the cavity. The space between the cavity and component and/or the at least one further layer portion is filled by resin flowed from one of the plurality of electrically insulating layer structures and/or from the at least one further layer portion. In an example, the component may be at least partially encapsulated by a mold material. This may result in, that the resin flowed from one of the plurality of electrically insulating layer structures and/or from the at least one further layer portion is in direct contact with the mold material. Preferably, the space laterally located next to the component may be filled by the resin flowed from one of the plurality of electrically insulating layer structures and/or from the at least one further layer portion. Additionally or alternatively, the space parallel to stacking direction next to the component may be filled by the resin flowed from one of the plurality of electrically insulating layer structures and/or from the at least one further layer portion. Preferably, the at least one further layer portion may be located with its full extension inside the cavity. Alternatively, the at least one further layer portion may protrude from the cavity and/or extend over the extension of the cavity in regard to stacking direction. In a further example, the space laterally located between the cavity and the at least one further layer portion may be fully filled by the resin flowed from one of the plurality of electrically insulating layer structures and/or from the at least one further layer portion.

According to the second aspect of the present invention, a method of manufacturing a component carrier is provided, wherein the method comprises the steps of: providing a stack comprising at least one electrically conductive layer structure and a plurality electrically insulating layer structures, (preferably thereafter) providing a cavity in the stack. Furthermore, the method comprises providing a component in the cavity and providing at least one further layer portion in the cavity. Moreover, the method comprises filling the space between the cavity and component and/or the at least one further layer portion by resin flowed from one of the plurality of electrically insulating layer structures and/or from the at least one further layer portion. Preferably, the method may comprise a consecutive order of process steps, wherein the order is identical as described above.

A component carrier according to the first aspect of the present invention is created, in which a component is embedded in a cavity and at least one further layer portion is at least partially filling the cavity wherein the space between the cavity and component and/or the at least one further layer portion is filled by resin flowed from one of the plurality of electrically insulating layer structures and/or from the at least one further layer portion. This may bring the advantage that the cavity may be at least partially prefilled by the volume of the at least one further layer portion and thus less material, for example resin, has to be provided, for example by flowing, from outside of the cavity into the cavity, compared to the situation when the cavity is free from the at least one further layer portion and/or a body occupying part of the volume of the cavity. For this reason, at least one electrically insulating layer structure providing the resin to fill the cavity may comprise less resin material a thus may be thin resulting in a compact overall component carrier. Additionally or alternatively, the resin flowed from one of the plurality of electrically insulating layer structures and/or from the at least one further layer portion may be close to the cavity and thus and easier filling of the cavity is achieved due to the shot distance. This circumstance may also ensure a reliable fully filling of the cavity, preferably thereby (avoiding-decreasing free internal volumes- bubbles). Further additionally or alternatively, the resin filling the space between the cavity and component and/or the at least one further layer portion may at least partially already be located inside the cavity due to the provision of at least one further layer portion in the cavity. This may further reduce the volume/space to be filled of the cavity by the resin flowed from one of the plurality of electrically insulating layer structures and/or from the at least one further layer portion. Due to the close proximity of the at least one further layer portion to the cavity, the cavity can be filled in a fast manner by resin originated from the at least one further layer portion and thus a higher manufacturing through put of the component carriers can be achieved.

In context of the present application, the term "embedding" may particularly denote that the component is in direct contact with an electrically insulating material originated from at least one electrically insulating layer structure and/or the at least one further layer structure. In an example, the electrically insulating material may be an encapsulant material. Preferably, at least one surface of the component may be in direct contact with the electrically insulating material. In particular, the term "fully embedding" may mean that at least three surfaces of a component are in direct contact with the electrically insulating material when considering a cross-sectional view. Preferably, one main surface of the component and two sidewalls of the component may be in direct contact with the electrically insulating material. More preferably, the at least three surfaces of the component may be fully covered by the electrically insulating material. Optionally, at least a portion of a fourth surface of the component may be in direction contact with the electrically insulating material. Further optionally, at least one connecting surface or connecting terminal of the component may be in direct contact with the electrically insulating material. In an example, the term embedding may also include that a molding material is provided in the cavity and at least partially encapsulating the component

In the context of the present application, the term "component carrier" may particularly denote any support structure which is capable of accommodating one or more components thereon and/or therein for providing mechanical support and/or electrical connectivity. A component carrier may also support thermal management, wherein the component carrier may in particular serve as a heat guiding and/or conduction structure, preferably supporting heat dissipation. In other words, a component carrier may be configured as a mechanical and/or electronic and/or thermal (acting) carrier for components. The component carrier may be configured to transmit electromagnetic waves.

In particular, a component carrier may be one of or may be configured as a printed circuit board (PCB), an interposer, in particular an organic interposer, and an IC (integrated circuit) substrate. A component carrier may also be a hybrid board combining different ones of the above-mentioned types of component carriers.

In some embodiments, a component carrier may in particular comprise one or more stacks and/or more than at least two electrically conductive layer structures. A component carrier may, for example, also comprise a solder resist layer structure and/or a protective layer structure. A protective layer structure may also be functionalized as an electrically conductive layer structure for at least one component.

In at least one embodiment, the component carrier may in particular be a laminate-type component carrier. In such an embodiment, the component carrier may in particular be a compound of multiple layer structures which are stacked one above the other and which are connected together by applying a pressing force and/or heat, in particular with simultaneous application of vacuum.

In the context of the present application, the term "printed circuit board" (PCB) may particularly denote a component carrier, in particular a plate-shaped component carrier, which is preferably formed by laminating several layer structures, for instance by applying pressure and/or by the supply of thermal energy. A PCB comprises in particular at least one insulating layer structure.

In at least one embodiment, in particular in a preferred embodiment of a PCB, the PCB is in particular formed by laminating several electrically conductive layer structures with several electrically insulating layer structures. The insulating layer structures may in particular be arranged in between the electrically conductive layer structures, wherein the electrically conductive layer structures and the insulating layer structures may be arranged alternating in stacking direction.

As preferred materials for PCB technology, the electrically conductive layer structures may be made of copper and/or contain at least a certain and defined amount of copper as it is well-known from prior art and usual, whereas the electrically insulating layer structures may comprise resin and/or glass fibers, so-called prepreg or FR4 material. The electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole may either connect the whole stack, (through-hole connections extending through several layers or the entire stack), or the filled hole may connect at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board may in particular be configured for accommodating one or more components on one or both opposing main surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

A dielectric part of a substrate (of an IC substrate) may be composed of resin with reinforcing particles (such as reinforcing spheres, in particular glass spheres).

In the context of the present application, the term "interposer" may in particularly denote a physical structure configured to bridge at least one electrical connection. An interposer may in particular be a physical interface layer structure. An interposer may in particular be configured to spread an electrical connection to a wider pitch and/or to bridge between different connection types. An interposer can be made of various materials, including silicon, glass, or organic substrates. An IC substrate or interposer may in particular comprise or consist of an inorganic layer structure or at least a layer of glass, silicon (Si) and/or a photo-imageable or dry-etchable organic material like epoxy-based build-up material (such as epoxy-based build-up film) or polymer compounds (which may or may not include photo- and/or thermosensitive molecules) like polyimide or polybenzoxazole as electrically insulating material.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular solder lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or sapphire and/or zirconia and/or cordierite and/or cordierite and/or steatite and/or forsterite and/or yttria and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride and/or gallium arsenide and/or indium phosphide. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above-mentioned example, such as: MoS₂, CuGaO₂, AgAlO₂, LiGaTe₂, AgInSe₂, CuFeS₂, BeO.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof. Additionally or alternatively, a component may be a physical body configured to be mounted on and/or to be embedded into a component carrier. For example, said physical body may be one of: a copper block, a glass block, a ceramic block, an inlay, a bridge, a PCB, an IC substrate, an interposer.

A component may in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microoptoelectromechanical system (MOEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component. Additionally or alternatively, the component may comprise a polymer waveguide and/or (optical) lenses and/or collimators and/or ferrules.

In the context of the present application, the term "stack" may particularly denote an arrangement of multiple planar layer structures which are mounted in parallel on top of one another. Some of the layer structures of the stack described herein may be stacked directly onto each other, that means with not further layer structure or component in between or indirectly, wherein between other layer structures described in the present application, further layer structures or components or the like may be arranged which are not described in the present application unless explicitly described to the contrary.

In the context of the present application, the term "electrically conductive layer structure" may particularly denote a layer structure which is electrically conductive. An electrically conductive layer structure may in particular comprise one or more conductive pathways, tracks, and/or signal traces and/or through connections such as vias and holes and/or interconnection structures for interconnection of the layers and/or for connection with other elements and/or components such as bumps, pillars or the like and/or nanowires. These electrically conductive structures may for example be etched from copper sheets and may, for example, be laminated onto an electrically non-conductive or electrically insulating layer structure, which the component carrier may comprise additionally in at least one embodiment. Additionally or alternatively, the electrically conductive layer structure may be produced by an additive process, for example SAP or mSAP, wherein SAP stands for "Semi-Additive Process" and mSAP denotes the "modified Semi-Additive Process", wherein both processes SAP and mSAP are well-known from prior art. In an example, the SAP and/or mSAP may comprise acidic conditions and/or alkaline conditions.

In at least one embodiment, the at least one electrically conductive layer structure of the component carrier comprises at least one of the following group consisting of: copper, aluminum, nickel, silver, gold, palladium, molybdenum, tungsten and magnesium and/or an alloy comprising at least one material component of the aforementioned group. Although copper is usually preferred, other materials or coated versions thereof are possible as well, in particular coated with supra-conductive material or conductive polymers, such as graphene or poly(3,4-ethylenedioxythiophene) (PEDOT) or polyaniline, respectively.

In the context of the present application, the term "electrically insulating layer structure" may denote a layer structure which is electrically non-conductive.

The at least one electrically insulating layer structure may comprise at least one of the following group consisting of: a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, (hollow) spheres or other kinds of filler particles, for example made of glass (multilayer glass) in order to form a composite, could be used as well. A semi-cured resin in combination with a reinforcing agent, for example fibers impregnated with the above-mentioned resins, is called prepreg and may also be used. These prepregs are often named after their properties for example FR4 or FR5, which describe their flame-retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating layer structures.

In the context of the present application, the term "layer structure" may particularly denote a continuous layer, a patterned layer or a plurality of nonconsecutive islands within a common plane. A layer structure can comprise at least one protruding element such as, for example, one or more solder bumps, copper bumps, pillars or other bonding structures like these, wherein the at least one protruding element may in particular protrude beyond the surface of a layer structure.

In at least one embodiment of the present invention, at least one body and/or layer structure of the component carrier may comprise a main surface, wherein in the context of the present application, the term "main surface" of a body or a layer structure may particularly denote one of the two largest opposing surfaces of the body or the layer structure or the outermost layer (structure) of the component carriers. The main surfaces may be connected by circumferential side walls. The thickness of a body or a layer structure, such as a stack, may be defined by the distance between the two opposing main surfaces, in particular in direction perpendicular to the extension of the main surface, in particular perpendicular to its planar extension.

In the context of the present application, the term "thickness direction" or "stacking direction" may particularly refer to a direction perpendicular to a planar extension of at least one layer structure of the stack.

In the context of the present application, the term "cavity" may particularly denote a recess or hollow space having been created within a structure of the component carrier, in particular in between parts and/or components and/or layers of the component carrier.

At least one cavity of the component carrier may have been created at least partially or completely by a mechanical manufacturing step, for instance by drilling and/or milling, in particular by laser drilling and/or mechanical drilling. Additionally or alternatively, an etching process may be used to create at least one cavity of the component carrier at least partially. However, material removal by laser drilling is preferred. This kind of material removal allows very precise and efficient material removal without significant introduction of mechanical stress or other significant unwanted effects into the surrounding material. Further, the resulting surface properties enable the establishment of high-quality electrical connections. In addition, laser material removal allows to handle various materials and a plurality of different cavity sizes in a very easy manner.

In the context of the present application, the term "further layer portion" may particularly denote a discrete element, in particular a distinct layer portion. Preferably, the further layer portion may comprise or consist of electrically insulating material. In an example, the further layer portion may comprise an electrically insulating layer structure, in particular a material of an electrically insulating layer structure. Additionally or alternatively, the further layer portion may comprise an inorganic layer structure and/or reinforcing material, for example reinforcing fibers and/or reinforcing particles. Preferably, the further layer portion may comprise organic material, in particular polymeric organic material, for example resin, which is at least partially flowable during the manufacturing process of the component carrier. The further layer portion may be a pre-manufactured body, for example an inlay. Additionally or alternatively, the further layer portion may comprise at least two layers, provided on top of each other regarding stacking direction. Further preferably, the further layer portion may be provided in the portion of the cavity not occupied by the component. In an example, the further layer portion can be distanced from the component. Additionally or alternatively, the further layer portion may be in contact with the component in the cavity. The further layer portion may comprise a regular shape, for example a rectangular shape or a circular shape_(for example obtained by the know dicing techniques to singularize portions of a layer-layer structure suitable for a component carrier within the context of the present invention), in regard to a cross-sectional view and/or top view. Additionally or alternatively, the further layer portion may comprise an irregular shape in regard to a cross-sectional and/or top view. Optionally, the further layer portion may comprise a stepped portion.

In the context of the present application, the term "the space between the cavity and component and/or the at least one further layer portion is filled by resin flowed from one of the plurality of electrically insulating layer structures and/or from the at least one further layer portion" may particularly denote that the material, in particular the resin, which is filling the space between the cavity and the component and/or the space between the cavity and the at least one further layer portion is a material originated from one of the plurality of electrically insulating layer structure and/or from the at least one further layer structure. During the manufacturing process elevated temperatures, for example higher than 70 °C, and/or a suitable compression forces on the stacked layers, may be applied resulting in that one of the plurality of electrically insulating layer structure and/or the at least one further layer structure (that are preferable at least partially uncured) become at least partially flowable and flow into the (adjacent) cavity filling the cavity. In an example, one of the plurality of electrically insulating layer structure and/or the at least one further layer structure may deform and expand into the cavity. The physical properties, for example, the flowability and/or the deformation, in particular the expansion, of one of the plurality of electrically insulating layer structures and/or the at least one further layer portion may be characteristics of the (organic, polymeric) resin material. Additionally or alternatively, two of the plurality of electrically insulating layer structure and/or at least two further layer structures and/or one of the plurality of electrically insulating layer structure and the at least one further layer structures may flow and merge and/or intermingle in the cavity (recognizable for example by the mixing of the fillers in the respective flowed material of the electrically insulating layer structures).

In the context of the present application, the term "adjacent" may particular denote that a cavity and one of the plurality of electrically insulating layer structure and/or the at least one further layer structure and/or a component are at least partially located in the same vertical level regarding thickness direction and are located in lateral close proximity next to each other. In an example, the cavity and one of the plurality of electrically insulating layer structure and/or the at least one further layer structure may be in direct lateral proximity to each other, defining at least one common boundary interface. In another example, the cavity and one of the plurality of electrically insulating layer structure and/or the at least one further layer structure may be laterally separated, in particular spaced, with each other, for example only by the resin flowed from one of the plurality of electrically insulating layer structures and/or from the at least one further layer portion and/or an electrically insulating layer structure and/or an encapsulant material. In a further example, the first component and the second component may be associated to the same portion. In a further example, the term "being adjacent" may include that the cavity and one of the plurality of electrically insulating layer structures and/or at least one further layer portion and/or an embedded component are stacked one above the other in stacking direction.

### Description of Exemplary Embodiments

According to a preferred embodiment of the present invention, the component may be embedded by resin flowed from one of the plurality of electrically insulating layer structures and/or from the further layer portion. In an example, the component may be at least partially embedded by resin flowed from one of the plurality of electrically insulating layer structures and/or from the further layer portion. Additionally or alternatively, the component may be fully embedded by resin flowed from one of the plurality of electrically insulating layer structures and/or from the further layer portion. This may bring the advantage of ensuring a reliable fixation of the component in the (stack of the) component carrier.

According to another embodiment of the present invention, the at least one further layer portion may be non-centred/non-planar with respect to the cavity. In an example, the center of gravity and/or the centroid of the at least one further layer portion may be laterally and/or spatially displaced compared with the center of gravity and/or the centroid of the cavity. In another example, the extension direction of one main surface of at least one further layer portion may be inclined, for example by an angle in the range from 1° to 45°, with the extension direction of the bottom of the cavity and/or at least one side wall of the cavity. This may bring the advantage of having a higher design flexibility of the manufacturing of the component carrier. Additionally or alternatively, since the at least one further layer portion is not perfectly aligned in the cavity, this may save time during the production and thus the misalignment is still in the specifications of the component carrier. The non-centred/non-planar position of the at least one further layer portion may compensate created stresses during manufacturing and thus may reduce the warpage of the component carrier.

In the context of the current document the term "non-planar" may refer to spatial arrangement of at least two objects or bodies one to each other. One surface, in particular one main surface, of a body, for example a further layer portion, may be inclined to another surface, in particular another main surface, of another body, for example another further layer portion and/or the bottom surface of the cavity. The inclination may be in at least one, in particular one or two, directions, for example in a Cartesian coordinate system. For example, one main surface of a further layer portion may be inclined in stacking direction and/or perpendicular to stacking direction in regard to another main surface of another further layer portion and/or the bottom surface of the cavity. In other words, the main surfaces of the respective further layer portions and/or the main surface of the further layer portion and the surface of the bottom of the cavity may not be parallel one to each other, for example along one direction and/or throughout the tridimensional space. Additionally or alternatively, the main surfaces of respective two further layer portions and/or the main surface of the further layer portion and the surface of the bottom of the cavity may be parallel and one extension direction of the main surface of one further layer portion may be rotated against a rotation axis being perpendicular to the main surface in regard to one extension direction of the main surface of another further layer portion and/or to one extension direction of the surface of the bottom of the cavity. In an example, the rotation angle and/or the inclination angle may be in the range from 1° to 89°, in particular in the range from 1° to 45°.

According to a preferred embodiment, the at least one further layer portions may be centred and/or planar with respect to the cavity.

According to an embodiment of the present invention, the at least of further layer portion may comprise a stepped portion in regard to a cross-sectional view and/or a top view. In an example, the stepped portion may comprise a corner and/or an edge, wherein the corner and/or edge comprises an angle in the range from 75° to 105°. This may bring the advantage of following to contour of the component embedded in the cavity and thus may ensure a reliable filling of the cavity. Additionally or alternatively, the component may be mechanically protected at at least two surfaces.

According to a further embodiment of the present invention, the component carrier may comprise at least two further layer portions partially filling the cavity. Preferably, the at least two further layer portions may be stacked one above each other in stacking direction. In an example, the at least two further layer portions may comprise a number of further layer portions in the range from two to ten, in particular in the range from two to eight. Additionally or alternatively, the at least two further layer portions may comprise a number of further layer portions in the range from two to fifty. In a further example, the at least two further layer portions may comprise the same material, for example (epoxy) resin, in particular (epoxy) resin comprising reinforcing material. Additionally or alternatively, the at least two further layer portions may comprise different material and/or different material composition. For example, the first further layer portion may comprise epoxy resin, whereas the second further layer portion may comprise polyimide. Additionally or alternatively, the first further layer portion may comprise reinforcing material, for example glass fibers, whereas the second further layer portion may be free from reinforcing material. This may bring the advantage of pre-filling the cavity with a plurality of further layer portions resulting in the fact that less volume/space between the cavity and the component and/or the at least two further layer portions has to be filled compared with the circumstance of providing one further layer portion.

According to a preferred embodiment of the present invention, the at least one further layer portion, in particular the at least two further layer portions, may form an inlay. This may bring the advantage that the inlay comprising at least one, in particular at least two, further layer portions may be pre-manufactured and inserted into the cavity. This may save time since a plurality of inlays can be manufactured within one manufacturing step.

According to another embodiment of the preset invention, the at least two further layer portions may be planarly shifted one to each other. In an example, the at least two further layer portions may not be congruent in regard to top view and/or planar view. In another example, at least a portion of one further layer portion may extend over, at least at one side, the extension of (an adjacent) other further layer portion when considering a planar and/or a cross sectional view. The portions of the respective further layer portions extending over the extension of other further layer portions may have local physical properties which can impart their properties to the stack. In an example, a portion of reinforcing fibers can extend over the extension of an adjacent other further layer portion. Said portion of reinforcing fibers can locally impart stiffening properties. Additionally or alternatively, the portions of the respective further layer portions extending over the extension of other further layer portions may act as an anchoring structuring and thus a reliable connection of the at least of the at least two layer portions two the stack is ensured.

According to a preferred embodiment, the at least two further layer portions may not be planarly shifted one to each other. In an example, the at least two further layer portions may be connected one to each other before bringing the at least two further layer portions into final shape. This may ensure a highly accurate form of the (connected) at least two further layer portions and may simplify the provision of the at least two further layer portions into the cavity.

According to a further embodiment of the present invention, the at least two further layer portions may be non-planar one to each other. This may be a finger print feature of the corresponding manufacturing process of the component carrier and thus ensures a reliable connection of the at least two further layer portions to the stack.

According to a preferred embodiment of the present invention, the at least two further layer portions may be planar one to each other. This may result from a process when connecting the at least two further layer portions and afterwards bringing the at least two further layer portions into final shape to be provided into the cavity.

According to a preferred embodiment of the present invention, between two adjacent further layer portions no electrically conductive layer structure may be located. Additionally, an electrically insulating layer structure and/or an electrically insulating material may be located between two adjacent further layer portions. This may bring the advantage of providing enough electrically insulating material, in particular resin, to ensure fully filling of the space between the cavity and component and/or the at least one further layer portion.

According to a further embodiment of the present invention, between two adjacent further layer portions an electrically conductive layer structure may be located. In an example, the electrically conductive layer structure may be a metal body, in particular a copper block or copper coin. This may bring the advantage of providing a shielding layer in close proximity to the component embedded in the cavity. For example, the shielding layer may shield the component from electromagnetic waves.

According to another embodiment of the present invention, two layer portions of the at least two further layer portions may comprise the same material. In an example, the first further layer portion may comprise (epoxy) resin and the second further layer portion may comprise (epoxy) resin. Additionally, at least one of the at least two further layer portion may comprise reinforcing material, for example glass fibers or glass spheres. Even if the amount and/or the composition and/or the shape of the reinforcing material is different, the materials of the respective further layer portions may be considered as the same. This may bring the advantage of reducing the amount of different materials inside the component carrier and thus warpage can be reduced since physical properties of the material are similar.

According to a further embodiment of the present invention, one of the at least two further layer portions may comprise different material compared with another one of the at least two further layer portions and/or an electrically insulating layer structure. In an example, one of the further layer portions may comprise organic material, in particular organic polymeric material, for example an electrically insulating layer structure and/or (epoxy) resin, whereas another of the further layer portions may comprise or consist of inorganic material, for example an inorganic layer structure. In another example, one of the further layer portions may comprise an organic material, for example (epoxy) resin, whereas another of the further layer portions may comprise a different organic material, for example poly (meth)acrylate and/or polyimide. This may bring the advantage of imparting different properties to the stack and/or component carrier, depending on the choice of the material having different physical and/or chemical properties.

According to a preferred embodiment of the present invention, the at least one further layer portion may have a different, in particular a smaller, planar extension than that of the main surface of the embedded component. Additionally or alternatively, the at least one further layer portion may have a bigger planar extension than that of the main surface of the embedded component and/or the planar extension of the at least one further layer portion and the planar extension of the main surface of the embedded component may be the same. This may simplify the embedding process of the component, since during the manufacture of the component carrier, in particular during the provision of the at least one further layer portion, a larger tolerance in regard to the placement of the at least one further layer portion exists.

According to another embodiment of the present invention, a plurality of components may be embedded in the cavity. In an example, at least two, in particular at least three, component may be embedded in the cavity. Preferably, the plurality of components may have the same height. Additionally or alternatively, the plurality of components may have a different height one to each other. Providing at least one further layer portion may efficiently embed a plurality of components in the cavity.

In the context of the present application, the term "height" may denote the thickness of the component (in stacking direction), in particular the maximum thickness of the component. In an example, the height may be determined by the distance between the external surface and the opposed external surface of the component in stacking direction. In another example, the height may be determined by the distance between of the component pads and the opposed (bottom surface) regarding stacking direction or the distance between of the component pads located on one side of the component and the component pads located on the opposed other side regarding stacking direction.

According to a further embodiment of the present invention, at least two of the plurality of components may have a different height one to each other. In an example, the first component may be a passive electronic component, for example a resistor and/or a capacitor, whereas the second component may be an active electronic component, for example a MOSFET. Typically, passive electronic components may have different heights compared to active electric components. The described method may give the opportunity of reliably fill the space between the cavity and the respective components having a different height one to each other and thus may ensure a vacancy free embedding of components having different heights.

According to a preferred embodiment of the present invention, the amount of further layer portions above one of the at least two components may be different than the amount of further layer portions above the other one of the at least two components. In an example, the amount of first further layer portions may be lower than the amount of second further layer portions. Preferably, the amount of first further layer portions may be one or two, whereas the amount of second further layer portions may be three or four or five. Alternatively, the amount of first further layer portions may be higher than the amount of second further layer portions. This may bring the advantage of adapting the amount of further layer portions to the height the respective component and thus may ensure a reliable embedding of respective components having different heights. In an example, the smaller the height of a component, the higher the amount of further layer portions relative to the cavity size in stacking direction.

According to another embodiment of the present invention, said at least two components may be provided in the (same) cavity. The described method may give the opportunity of reliably fill the space between the cavity and the respective components and/or the space between the respective components having a different height one to each other and thus may ensure a vacancy free embedding of components having different heights.

According to a further embodiment of the present invention, the stack may comprise a plurality of cavities. Preferably, each of the cavities is filled by at least one further layer portion. In an example, the stack may comprise at least two, in particular at least three cavities. In a further example, the respective cavities may have different sizes in planar and/or stacking direction one to each other. Additionally or alternatively, the respective cavities may have the same size in planar and/or stacking direction. In another example, the respective cavities may have different shapes one to each other. Additionally or alternatively, the respective cavities may have the same shape. This may enable to create a complex component carrier having a plurality of cavities, each having a component embedded inside, preferably electrically interconnected with each other.

According to a preferred embodiment of the present invention, a first cavity of said plurality of cavities may comprise a component with a first height, a second cavity of said plurality of cavities may comprise a component with a second height and the heights of the respective components may be different one to each other.

According to another embodiment of the present invention, one and/or the first cavity of said plurality of cavities may be partially filled by a different amount of further layer portions compared with those in a further one and/or the second cavity of said plurality of cavities. Additionally or alternatively, one and/or the first cavity of said plurality of cavities may be partially filled by the same amount of further layer portions compared with those in a further one and/or the second cavity of said plurality of cavities. This may bring the advantage of adapting the amount of further layer portions to the height the respective component and thus may ensure a reliable embedding of respective components having different heights. In an example, the smaller the height of a component, the higher the amount of further layer portions relative to the cavity size in stacking direction.

According to a further embodiment of the present invention, the further layer portions in the respective cavities may be misaligned one to each other. According to a preferred embodiment of the present invention, at least two further layer portions may be differently misaligned in the respective cavities. According to another embodiment of the present invention, at least two further layer portions may be misaligned in the respective cavities along the same planar direction. In an example, the misalignment may comprise a shift in stacking direction and/or a shift in lateral direction and/or an inclination of the direction of the main surfaces of a further layer portion in regard to a cross sectional view to the direction of the main surface of another further layer portion. The misalignment of the further layer portions may be a footprint of an individual placement of the respective further layer portions on an electrically insulating layer structure, especially when the respective further layer portions are located in respective cavities. Additionally or alternatively, the misalignment of the further layer portions may be a footprint of a formation of the further portions with a common process, for example by an etching process of an electrically insulating layer structure, especially when the at least two further layer portions are misaligned in the respective cavities along the same planar direction.

Additionally or alternatively, at least two further layer portions may not be misaligned in the respective cavities. Further additionally or alternatively, at least two further layer portions may not be misaligned in the respective cavities along the same planar direction.

According to a preferred embodiment of the present invention, the at least one of the further layer portions may comprise fillers, in particular filler particles. In an example, the filler particles and/or fillers may comprise inorganic material, for example silicon and/or titanium and/or magnesium and/or barium and/or calcium, in particular the oxides and/or sulfates of the aforementioned elements. In another example, the filler particles may comprise different size, for example in the range from 100 nm to 30 µm, and/or different shape, for example plate shape and/or fibers and/or plate shape and/or rounded shape, e.g. sphere. In a further example, the filler particles may be porous filler particles. This may bring the advantage of imparting and/or modifying the physical and or chemical properties, for example fire resistance and/or flow behavior, of the at least one further layer portion.

According to a further embodiment of the present invention, at least two further layer portions may comprise different kinds of filler (particle) material and/or filler (particle) composition and/or filler (particle) shape one to each other. In an example, a further layer portion may comprise fibers, whereas another further layer portion may comprise spheres. In another example, a further layer portion may comprise filler material comprising silicon, whereas another layer portion may comprise filler material comprising magnesium and/or calcium. This may bring the advantage of imparting a plurality of different physical and/or chemical properties to the stack, in particular the at least two further layer portions.

According to another embodiment of the present invention, the fillers may comprise cloth-woven fillers. This may enhance the stiffness of the at least one further layer portion.

According to a preferred embodiment of the present invention, the filler particles may be randomly distributed in the at least one further layer portion. This may be a footprint of the manufacturing process, since the resin of the at least one further layer portion is flowing into the space between the cavity and the component and/or the at least one further layer portion. Due to complex flow behavior created by elevated temperatures, for example higher than 70 °C, and/or elevated pressure, for example higher than 1.5 bar, during manufacturing the local flow behavior of the filler particles may be different resulting in a random distribution of said fillers in the at least one further layer portion. Said filler particle distribution may be the indication of the resin flowing direction, and/or may be the indication of the kind of interaction between the flowing resin and other matching bodies. For example, in case of matching of the flowing resin with a hardened body, such as a fully cured resin, the fillers may result to be not exposed to the boundary surface between the flowed resin and the hardened body, whereas in case of matching of the flowing resin with a flowing body/resin, the fillers may result to be exposed at the boundary surface between the two bodies, in particular showing an intermingling between the two flowed materials.

According to another embodiment of the present invention, the flowed resin encapsulating the component may be provided between the cavity wall and the component. This may ensure a fully and reliable filling of the cavity and/or a vacancy-free embedding of the component.

According to a further embodiment of the present invention, the flowed resin may be in contact with at least a portion of one main surface of the component. In an example, the flowed resin may be in contact with a corner region and/or edge region of the component. Additionally or alternatively, the flowed resin may be in contact with an entire main surface of the component. This may enhance the integrity of the stack, since additional adhesion is provided to the component via at least one main surface.

According to a preferred embodiment of the present invention, the cavity may be closed at at least one vertical extremity, in particular at both opposed extremities, by at least one layer structure composing the stack. Preferably, the at least one layer structure closing at least one vertical extremity may comprise or consist of an electrically insulating layer structure. Additionally or alternatively, the at least one layer structure closing at least one vertical extremity may comprise or consist of an electrically conductive layer structure. In case an electrically insulating layer structure is closing the cavity, additional resin for filling the space between the cavity and the component and/or the further layer portion can be provided, in particular at a spatial direction of the cavity being parallel to stacking direction. In case an electrically conductive layer structure is closing the cavity, a short electrically conductive connection to the component, in particular its connection terminals, can be achieved.

According to a further embodiment of the present invention, the cavity may be closed at at least one vertical extremity, in particular at both opposed extremities, by resin flowed from one of the plurality of electrically insulating layer structures and/or from the at least one further layer portion. This may bring the advantage of not needing further material, in particular further resin material, to fully fill the cavity, in particular without vacancies enclosed. Additionally or alternatively, the may bring the advantage of creating a thin component carrier, since only one electrically insulating layer may be needed.

According to another embodiment of the present invention, the cavity may be closed by at least one of the plurality of electrically insulating layer structures. Additionally or alternatively, the cavity is closed by at least one further layer portion. In an example, the at least one of the plurality of electrically insulating layer structures and/or the at least one further layer portion may define at least a portion of the cavity and/or may be adjacent to the cavity.

According to a further embodiment of the present invention, the flowed resin closing at least one vertical extremity of the cavity may flow from at least one of the plurality of electrically insulating layer structures. Additionally or alternatively, the flowed resin closing at least one vertical extremity of the cavity may flow from at least one further layer portion. In an example, the vertical extremity of the cavity comprises reinforcing material and/or filler particles originated from the resin flowed from the at least one of the plurality of electrically insulating layer structures and/or the at least one further layer portion. In another example, the flowed resin closing at least one vertical extremity of the cavity may originate from lateral direction and/or from direction being parallel to stacking direction. Closing the cavity by at least one of the plurality of electrically insulating layer structures and/or at least one further layer portion, in particular by resin flowed from at least one of the plurality of electrically insulating layer structures and/or resin flowed from at least one of the plurality of electrically insulating layer structures may bring the advantage of closing the cavity by locally close by and/or adjacent material resulting in a reliable and/or vacancy free filling of the cavity.

According to a preferred embodiment of the present invention, the opposed vertical extremities of the cavity may have the same planar extension. Additionally or alternatively, the opposed vertical extremities of the cavity have different planar extension. This may relate and depend on the manufacturing process of the cavity formation, for example by mechanical drilling and/or laser drilling.

According to another embodiment of the present invention, the at least one further layer portion in the cavity may be in contact with the at least one layer structure composing the stack. In an example, a reinforcing material, in particular a glass fiber, of the at least one further layer portion may be in contact with the at least one layer structure composing the stack. In another example, the at least one layer structure may be an electrically conductive layer structure and/or an electrically insulating layer structure. Preferably, a main surface of at least one further layer portion may be in direct contact with a main surface of at least one layer structure composing the stack. This may bring the advantage of ensuring a reliable and/or stable mechanical interconnection, for example for adhesion, between the at least one further layer portion and the at least one layer structure and thus may enhance the integrity of the component carrier.

According to a further embodiment of the present invention, between the at least one further layer portion and the at least one layer structure composing the stack no electrically conductive layer structure may be located. Preferably, the at least one layer structure composing the stack may comprise or consist of an electrically insulating layer structure. Additionally or alternatively the at least one further layer portion and the at least one layer structure composing the stack may comprise the same material, for example (epoxy) resin and/or poly (meth)acrylate. This may bring the advantage of ensuring a highly stable mechanical connection, for example by cohesion and/or adhesion, between the between the at least one further layer portion and the at least one layer structure composing the stack avoiding delamination between the two aforementioned constituent of the stack. Additionally or alternatively, between the at least one further layer portion and the at least one layer structure composing the stack an electrically conductive layer structure may be located.

According to a preferred embodiment of the present invention, the at least one layer structure composing the stack may be deformed toward the component at the area of the cavity. Preferably, the at least one layer structure comprises electrically insulating material, in particular (epoxy) resin and/or poly (meth)acrylate. This may result from the applied manufacturing process, for example including elevated temperatures, in particular higher than 70 °C, and/or elevated pressure, in particular higher than 1.5 bar. This may bring the advantage of strengthening the component carrier by a mechanical reinforcement since the at least one layer structure is connecting the stack with the portion/area of the cavity. Optionally, the deformation of the at least one layer structure composing the stack may include a bending of the material, for example from a direction being parallel to stacking direction to a direction being perpendicular to stacking direction or vice versa.

According to another embodiment of the present invention, the deformation may comprise a dimple of the at least one layer structure composing the stack toward the component. Additionally or alternatively, the deformation may comprise another shape in regard to a dimple, for example trench. This may bring the advantage of providing an indentation, which can be used for mechanical fixation of electrically conductive layer structures and/or electrically insulating layer structures.

According to a further embodiment of the present invention, the at least one layer structure composing the stack may comprise an embedded reinforcing structure, said reinforcing structure being deformed toward the component at the area of the cavity. Preferably, the reinforcing structure may bend from a direction being perpendicular to stacking direction to a direction being parallel to stacking direction. Additionally or alternatively, the reinforcing structure may stretch into the area of the cavity. In an example, the reinforcing structure may be the same as the reinforcing material. Additionally or alternatively, the reinforcing structure may be different than the reinforcing material. The reinforcing structure may comprise reinforcing fibers and/or reinforcing spheres. This may result from the applied manufacturing process, for example including elevated temperatures, in particular higher than 70 °C, and/or elevated pressure, in particular higher than 1.5 bar. This may bring the advantage of imparting physical and/or chemical properties of the reinforcing structure into the area of the cavity.

According to a preferred embodiment of the present invention, the deformation of the at least one layer structure composing the stack and/or the reinforcing structure may contribute to the contact of the at least one further layer portion with the component. In an example, the reinforcing structure may be in direct contact with the at least one further layer portion. Due to the deformation of the at least one layer structure, the at least one further layer portion may be pushed in direction towards the component.

According to a further embodiment of the present invention, the at least one further layer portion may be attached to the component. Preferably, an interface between the at least one further layer portion and the component is apparent. In an example, an adhesive layer is in direct contact with the at least one further layer portion and the component. Additionally or alternatively, the adhesive layer is located between the component and the at least one further portion. The adhesive layer may comprise a material being different than the electrically insulating layer structure and/or the at least one further layer portion. Alternatively, the adhesive layer may comprise a material being the same as the electrically insulating layer structure and/or the at least one further layer portion. In an example, the adhesive layer may comprise organic material, in particular organic polymeric material. In another example, the adhesive layer may comprise (epoxy) resin and/or polyimide and/or poly (meth)acrylate. This may bring the advantage of having a reliable mechanical interconnection between the component and the at least one further layer portion. Additionally or alternatively, the at least one further layer portion can be attached to the component and the at least one further layer portion and the component can be provided into the cavity within one assembly step. This may save time and may ensure a high alignment accuracy.

According to another embodiment of the present invention, the at least one further layer portion may comprise a dummy component. The dummy component may comprise a copper body and/or a silicon body and/or a ceramic body and/or a glass body and/or a core structure. This may bring the advantage of adjusting the height of the at least one further layer portion in an easy manner by proper choice of the dummy component. Additionally or alternatively, the dummy component may impart additional physical and/or chemical properties into the component carrier. For example, the copper body and/or the silicon body may be used for heat guiding. In another example, the glass body may be used for electromagnetic wave, in particular light, transmission.

According to a further embodiment of the present invention, the at least one further layer portion may be a solid and/or not flowable and/or a cured element. In an example, the at least one further layer portion may comprise organic polymeric material, which has non-flowable properties and/or may be in a solid state and/or cured state. Additionally or alternatively, the at least one further layer portion may comprise inorganic material, which has non-flowable properties and/or may be in a solid state and/or cured state. This may bring the advantage of an easy and precise handling of the at least one further layer portion due to the solid and/or not flowable and/or cured properties.

In the content of this document, the term "cured" may particularly denote that the material comprises a molecular and/or atomic network, which imparts a solid property to the material. In an example, at least 50% of the atoms and/or molecules of the material may be part of the network. In another example, less than 99.5% of the atoms and/or molecules of the material may be part of the network. Preferably, a cured element and/or a cured material may comprise an organic polymeric material, for example (epoxy) resin and/or poly (meth)acrylate.

According to a preferred embodiment of the present invention, the at least one further layer portion may comprise a thermal insulating material. Preferably, the at least one further layer portion may comprise a thermally insulating resin, for example an aerogel. Additionally or alternatively, the thermally insulating material may comprise a thermal conductivity lower than 50 W/mK, in particular lower than 10 W/mK, more in particular lower than 5 W/mK. This may bring the advantage of protecting the component from thermal impact, for example heat.

According to another embodiment of the present invention, the at least one further layer portion may comprise a thermal conductive material. In an example, the thermal conductive material may comprise a metal body and/or metal block, for example copper and/or silicon. Additionally or alternatively, the thermally conductive material may comprise an inlay comprising metal, for example copper and/or silver. In another example, the thermally conductive material may comprise a thermally conductive ceramic, for example a thermally conductive ceramic block. Optionally the thermally conductive ceramic may comprise elementary metal, for example the thermally conductive ceramic may comprise at least one metal coated surface, in particular said coated surface can comprise at least one metal layer, in particular with a different planar extension than that of the ceramic body, more in particular defining a (lateral) step profile. Additionally or alternatively, the thermally conductive material may comprise a thermal conductivity higher than 50 W/mK, in particular higher than 100 W/mK. This may bring the advantage of removing heat from the (adjacent) component in an easy and efficient way.

According to a further embodiment of the present invention, the method of manufacturing the component carrier may comprise the step of providing said at least one further layer portion, in particular at least two further layer portions, on at least one of the (plurality of) layer structures composing the stack before to provide the at least one further layer portion in the cavity. Additionally or alternatively, the at least one further layer portion may be provided in the cavity and afterwards the at least one of the (plurality of) layer structures composing the stack is provided. This may save time during manufacturing of the component carrier, especially when at least two further layer portions are attached to the at least one of the (plurality of) layer structures.

According to a preferred embodiment of the present invention, the method of manufacturing the component carrier may comprise the step of forming said at least one further layer portion through a patterning step of at least one layer structure composing the stack. In an example, at least one layer structure, for example an electrically insulating layer structure, in particular a plurality of layer structures, for example at least one electrically insulating layer structure and/or at least one electrically conductive layer structure, may be structured to form at least one further layer portion in a separate manufacturing step. Optionally the patterning step may comprise forming an inlay composing the at least one further layer portion. Additionally or alternatively, the patterning step may comprise dicing an electrically insulating layer structure, in particular a plurality of electrically insulating layer structures, to obtain the at least one further layer portion. Forming the at least one further layer portion in a separate manufacturing step may bring the advantage of checking the at least one further layer portion for manufacturing errors and thus only further layer portion, which passed an inspection/being free from an error may be provided to the component carrier.

The preferred embodiments presented with reference to a component carrier according to the first aspect of the present invention and its advantages apply correspondingly to a method according to the second aspect of the present invention.

Further features of the invention are shown in the claims, the figures, and the description of the figures. All the features and combinations of features mentioned above in the description as well as the features and combinations of features mentioned below in the description of the figures and/or shown alone or in combination in the figures can be used not only in the combination as indicated or shown in each case, but also in other combinations or on their own so far it can technically be realized.
Figure 1 to Figure 4 illustrate cross-sectional views of structures obtained during carrying out a first sequence of a method of manufacturing a component carrier according to an exemplary embodiment of the invention.
Figure 5 to Figure 8 illustrate cross-sectional views of structures obtained during carrying out a second sequence of a method of manufacturing a component carrier according to an exemplary embodiment of the invention.
Figure 9 illustrate a microscopic image of a cross-sectional views of a component carrier according to an exemplary embodiment of the invention.
Figure 10 illustrate a microscopic image of a cross-sectional views of a component carrier according to another exemplary embodiment of the invention.
Figure 11 illustrate a microscopic image of a cross-sectional views of a component carrier according to a further exemplary embodiment of the invention.
Figure 12 illustrate an image of a further layer portion according to a further exemplary embodiment of the invention.
Figure 13 illustrate a microscopic image of a cross-sectional views of a component carrier according to a further exemplary embodiment of the invention.
Figure 14 illustrate cross-sectional view of a component carrier according to an exemplary embodiment of the invention.
Figure 15 illustrate cross-sectional view of a component carrier according to an exemplary embodiment of the invention.
Figure 16 illustrate cross-sectional view of a component carrier according to an exemplary embodiment of the invention.
Figure 17 illustrate cross-sectional view of a component carrier according to an exemplary embodiment of the invention.

### Detailed Description

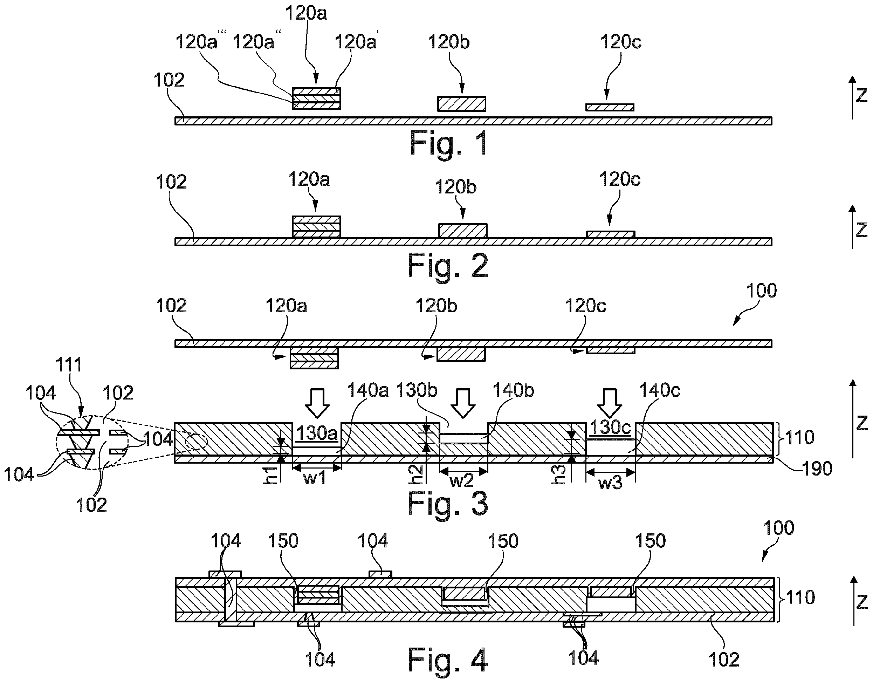

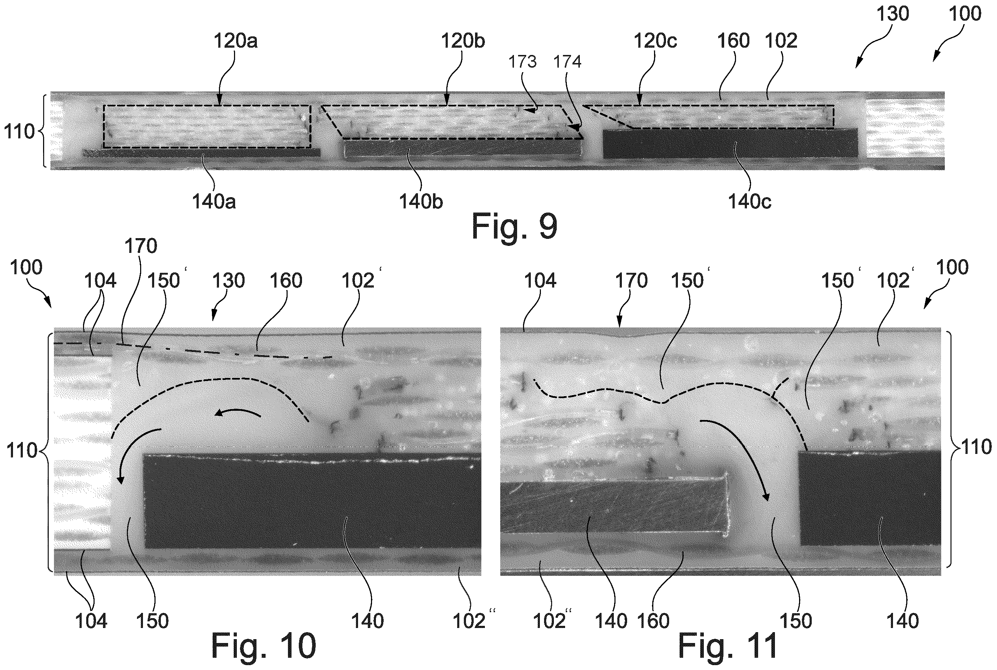

A component carrier 100, for example as shown in Figure 9 or similar, can be manufactured by a combination of the explained process steps described in Figure 1 to Figure 4.

Figure 1 shows an exploded cross-sectional view of an electrically insulating layer structure 102 and three further layer portions 120a,b,c, in particular a first further layer portion 120a, a second further layer portion 120b and a third further layer portion 120c, according to an exemplary embodiment of the present invention. Preferably, the three further layer portions may be located on one and/or the same side of the electrically insulating layer structure 102 in regard to the stacking direction Z. As can be seen by Figure 1, the three further layer portions 120a,b,c are distinct one from each other and are laterally located besides each other. Additionally, the three further layer portions 120 are spaced from each other. Preferably, at least two further layer portions may be stacked one above the other in regard to stacking direction Z (see the first further layer portion 120a', 120", 120"'). Additionally or alternatively, the first further layer portion 120a, in an example 120a", may comprise a dummy component, for example a copper body and/or a silicon body and/or a ceramic body and/or a glass body. In an example, the at least two further layer portions 120a,b,c may comprise the same material. In another example, the at least two further layer portions 120a,b,c may comprise different material compared with another one of the at least two further layer portions 120a,b,c and/or an electrically insulating layer structure 102. The respective further layer portions 120a,b,c have different heights one to each other. In an example, the first further layer portion 120a may comprise a height greater than height of the second further layer portion 120b and the height of the third further layer portion 120c. In another example, the height of the third further layer portion 120c may be smaller than the height of the first further layer portion 120a and the height of the second further layer portion 120b. In a preferred example, the electrically insulating layer structure 102 may have adhesive properties.

Figure 2 shows a cross-sectional view of a precursor of a component carrier 100 according to an exemplary embodiment. The electrically insulating layer structure 102 and the three further layer portions 120a,b,c explained in Figure 1 are connected to each other. This may be achieved by applying elevated temperatures, for example higher than 70 °C, and/or elevated pressure, for example higher than 1.5 bar and/or by an intermediate layer structure, such as an adhesive structure. The three further layer portions 120a,b,c are in direct contact with the electrically insulating layer structure. Preferably, between the respective further layer portions 120 and the electrically insulating layer structure no electrically conductive layer portion is located.

Figure 3 shows an exploded cross-sectional view of a component carrier 100 according to an exemplary embodiment of the present invention. In an example, the component carrier 100 may be composed of a first/top part and a second/bottom part. The first/top part of Figure 3 the precursor of a component carrier 100 shows Figure 2 flipped upside down. The second/bottom part of Figure 3 comprises a stack 110 comprising at least one electrically conductive layer structure 104 and at least one, in particular a plurality of electrically insulating layer structures 102. As can be seen in the magnification 111, the stack 110 may comprise a plurality of electrically conductive layer structures 104 located one above the other in regard to stacking direction Z. Preferably, the stack 110 may comprise or consist of a fully cured organic polymeric material, for example a core material. Additionally or alternatively, the stack 110 may comprise an inorganic layer structure, for example a glass core. Preferably, the electrically conductive layer structure 104 may comprise or consist of metal, for example copper and/or silver, and/or an alloy, for example brass. Additionally or alternatively, the electrically conductive layer structure may have a thickness in regard to stacking direction Z in the range from 2 µm to 500 µm, more preferably, in the range from 4 µm to 50 µm. The electrically conductive layer structures 104 are separated from each other by respective electrically insulating layer structures 102, which are sandwiched between two adjacent electrically conductive layer structures 104. In an example, the electrically insulating layer structure 104 may comprise organic material, in particular organic polymeric material, for example epoxy resin and/or poly (meth)acrylate. In another example, the electrically insulating material 102 may comprise a prepreg or a photo-imageable dielectric. Additionally or alternatively, the electrically insulating layer structure 102 may have a thickness in regard to stacking direction Z in the range from 5 µm to 1500 µm, in particular in the range from 5 µm to 150 µm, more in particular in the range from 10 µm to 100 µm. Two electrically conductive layer structures 104, in particular two adjacent electrically conductive layer structures, are vertically connected with each other by a vertical interconnection. Preferably, the vertical interconnection may comprise electrically conductive properties. Optionally, the (electrically conductive) vertical interconnection may be a component of the electrically conductive layer structure 104. The stack 110 is preferably in contact with a temporary carrier structure 190. Preferably, at least a portion, more preferably a main surface, of the temporary carrier structure 190 comprises adhesive properties. In an example, one main surface of the stack 110 is in contact with the temporary carrier structure 190. Additionally, the stack 110 comprises a plurality, in this example three, cavities 130a,b,c, in particular a first cavity 130a, a second cavity 130b and a third cavity 130c. The cavities 130a,b,c may comprise through cavities, vertically extending through the entire thickness of the stack 110, in this Figure the first cavity 130a and the third cavity 130c. Alternatively, at least one cavity 130 may be composed of a blind cavity, in this Figure the second cavity 130b. In the shown example, the opposed vertical extremities of the respective cavities 130 have the same planar extension. The shown three cavities 130 are separated one to each other. Each respective cavity 130 hosts a component 140. In Figure 3, a first component 140a is located in a first cavity 130a, a second component 140b is located in a second cavity 130b and a third component 140c is located in a third cavity 130c. The respective components 140 have a different height one to each other. In particular, the first component 140a comprises a first height h1 and a first planar extension defining a first width w1, the second component 140b comprises a second height h2 and a second planar extension defining a second width w2 and the third component 140c comprises a third height h3 and a third planar extension defining a third width w3. The shown respective heights h1 to h3 are different one to each other; additionally or alternatively the respective widths w1 to w3 may be the same. Additionally or alternatively, at least two of the components 140 may comprise the same heights h and/or different widths w one to each other. Optionally, at least one component 140 may comprise a smaller width w than the height h. In an example, the first components 140a and the third component 140c are in direct contact with the temporary carrier structure 190. Additionally or alternatively, the respective components 140 may be distanced from the temporary carrier structure 190, in particular by the bottom wall of the blind cavity, see the second component 140b. Preferably, the first/top part of the component carrier 100 and the second/bottom part of the component carrier 100 may be located such, that the first further layer portion 120a is shifted parallel to stacking direction Z in regard to the first cavity 130a, that the second further layer portion 120b is shifted parallel to stacking direction Z in regard to the second cavity 130b and that the third further layer portion 120c is shifted parallel to stacking direction Z in regard to the third cavity 130c.

Figure 4 shows a cross-sectional view of a component carrier 100 according to an exemplary embodiment of the present invention. In addition to Figure 3, the two parts, in particular the top part and the bottom part, of the component carrier 100 are connected one to each other. This may be achieved by the application of elevated temperatures, for example larger than 70 °C, and/or elevated pressure, for example larger than 1.5 bar. Thereby, the first further layer portion 120a is at least partially located inside the first cavity 130a and/or at least partially filling the first cavity 130a. Additionally or alternatively, the second further layer portion 120b is at least partially located inside the second cavity 130b and/or at least partially filling the second cavity 130b. Further additionally or alternatively, the third further layer portion 120c is at least partially located inside the third cavity 130c and/or at least partially filling the third cavity 130c. Preferably, the electrically insulating layer structure 102 may at least partially fill at least one, in particular all, cavities 130a,b,c. The sum of the heights of the first component 140a and the first further layer structure 120a and/or the sum of the heights of the third component 140c and the third further layer structure 120c are the same as the thickness of the stack 110 in regard to stacking direction Z. Additionally or alternatively, the sum of the heights of the second component 140b and the second further layer structure 120b may be different than the thickness of the stack 110 in regard to stacking direction Z. In an example, the sum of the thickness of further layer portion and height of the component may be (slightly) larger than the thickness of the cavity before the lamination. During the connection of the two parts, the further layer portion may be compressed in stacking direction Z thereby laterally providing resin to flow into the cavity and preferably fully filling the cavity. The space between the respective cavities 130a,b,c and the respective further layer portions 120a,b,c and/or components 140a,b,c is filled by the resin 150 flowed from one of the plurality of electrically insulating layer structures 102 and/or from the at least one further layer portion 120. The first further layer portion 120a has a different, in particular smaller, planar extension that that of the main surface of the first component 140a and/or the cavity 130a. Additionally or alternatively, the second further layer portion 120b has a different, in particular smaller, planar extension that that of the main surface of the second component 140b and/or the cavity 130b, and/or the third further layer portion 120c has a different, in particular smaller, planar extension that that of the main surface of the third component 140c and/or the cavity 130c. In case of the embodiment, the temporary carrier 190 is provided, said temporary carrier structure 190 may be removed after the lamination of the stack 110, in particular when the components 140a,b,c are firmly embedded in the stack 110. This a may be done by a stripping process. Additionally or alternatively, the temporary carrier structure 190 may be mechanically removed. A further electrically insulating layer structure 102 may be attached to the component carrier 100 at the position where the temporary component carrier 190 was located. Thereby the stack may be enlarged by the further electrically insulating layer structure 102. The further electrically insulating layer structure 102 may be in direct contact with an electrically conductive layer structure 104 and/or an electrically insulating layer structure 102 and/or respective components 140. Additionally or alternatively, the respective further layer portions 120 may be free from contact with the further electrically insulating layer structure 102. At the exposed surfaces of the component carrier 100 at least one further electrically conductive layer structure 104 is located. This can be achieved by a galvanic process. Additionally or alternatively, a further layer of electrically conductive material can be attached and may be structured by a material removal process, for example by an etching process. Preferably, the further electrically conductive layer structure 104 may be in direct contact with at least one component 140, in this example the third component 140c, and/or the electrically insulating layer structure 102. This can be achieved by a chemical vapor deposition process and/or a physical vapor deposition process, for example by sputtering. The further electrically conductive layer structure 104 is in direct contact with the electrically insulating layer structure 102. Additionally or alternatively, the further electrically conductive layer structure 104 may be in direct contact with at least one further layer portion 120. The exposed further electrically conductive layer structures 104 may comprise a surface finish, for example gold, tin and/or ENIPIG. Additionally, the exposed further electrically conductive layer structures 104 are vertically connected with each other by a through vertical connection. The through vertical connection may be electrically conductive and/or may comprise electrically conductive material, for example metal, in particular copper. The further electrically conductive layer structure 104 is connected to (a main surface of) the first component 140a. Additionally or alternatively, the further electrically conductive layer structure 104 may be connected to the second component 140b and/or the third component 140c. Additionally or alternatively, the exposed surface of the component carrier 100 may comprise solder resist material. Preferably, the respective further layer portions may be free from direct contact with the temporary carrier structure 190 and/or may be located at the opposed main surface of the respective components 140, which is in direct contact with the temporary carrier 190 in regard to stacking direction Z. Additionally or alternatively, the first further portion 120a may be free from direct contact with the second further layer portion 120b and/or the second component 140b and/or the third further layer portion 120c and/or the third component 140c. Further additionally or alternatively, the second further portion 120b may be free from direct contact with the first further layer portion 120a and/or the first component 140a and/or the third further layer portion 120c and/or the third component 140c. Further additionally or alternatively, the third further portion 120c may be free from direct contact with the first further layer portion 120a and/or the first component 140a and/or the second further layer portion 120b and/or the second component 140b. The combined heights of the first component 140a and the first further layer portion 120a are the same as the combined heights of the second component 140b and the second further layer portion 120b and/or the combined heights of the third component 140c and the third further layer portion 120c. Additionally or alternatively, the combined heights of the first component 140a and the first further layer portion 120a may be different than the combined heights of the second component 140b and the second further layer portion 120b and/or the combined heights of the third component 140c and the third further layer portion 120c.

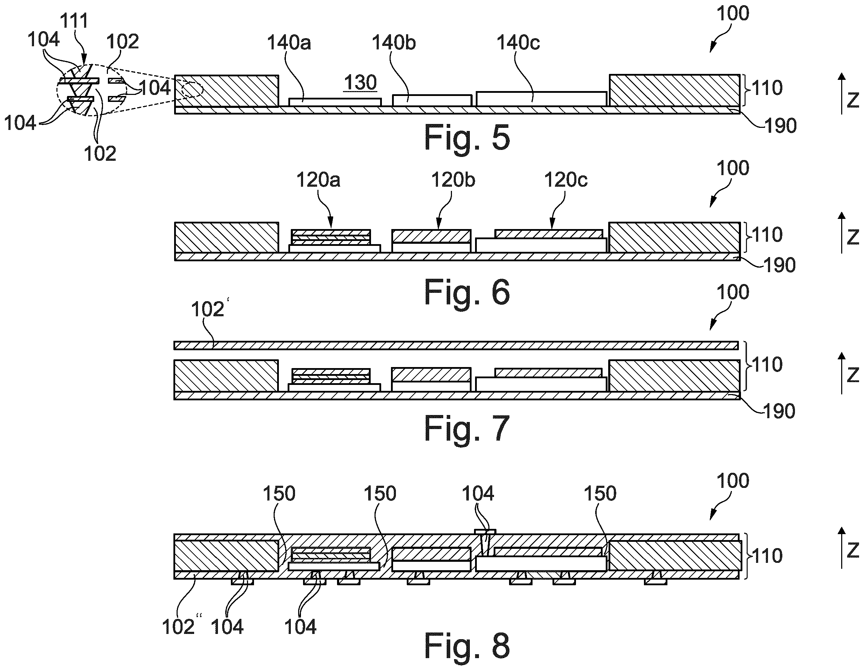

A component carrier 100, for example as shown in Figure 9 or similar, can be manufactured by a combination of the explained process steps described in Figure 5 to Figure 8.

Figure 5 shows a cross-sectional view of a component carrier 100 according to an exemplary embodiment of the present invention. The component carrier 100 comprises a stack 110 comprising at least one electrically conductive layer structure 104 and a plurality electrically insulating layer structures 102, as can be seen by the magnification 111. Additionally, the stack 110 comprises a cavity 130 preferably fully extending through the thickness of the stack 110 in regard to stacking direction Z. The stack 110, in particular one main surface of the stack 110, may be in direct contact with a temporary carrier structure 190. As can be seen in Figure 5, a plurality, in particular a first component 140a, a second component 140b and a third component 140c, is located inside the cavity 130. In the shown embodiment, the first component 140a, the second component 140b and the third component 140c have a different height one to each other. Preferably, the width of the cavity 130 may be larger than the sum of the width w of the respective three components 140. Preferably, the respective components 140 are in direct contact with the temporary carrier structure 190. More preferably, the respective heights h of the components may be smaller than the thickness of the stack 110 and/or the components 140 have respective heights h. The respective components 140 are located such, that they are free from direct contact from each other.

Figure 6 shows a cross-sectional view of a component carrier 100 according to another exemplary embodiment of the present invention. Additionally to Figure 5, Figure 6 comprises a first further layer portion 120a, a second further layer portion 120b, and a third further layer portion 120c. The respective further layer portions 120 have different heights in regard to stacking direction Z one to each other. Additionally or alternatively, respective further layer portions 120 have different width in regard perpendicular to stacking direction Z. In an example, the width (w1 compare with Figure 3) of the first component 140a is different to the width of the first further layer portion 120a. In another example, the width (w2 compare with Figure 3) of the second component 140b is the same as the width of the second further layer portion 120b. Preferably, the further layer portions 120 may be a pre-manufactured layer portions and/or may be a pre-manufactured inlays. Said further layer portions 120 are located such that, the first further layer portion 120a is in direct contact with the first component 140a, that the second further layer portion 120b is in direct contact with the second component 140b and that third further layer portion 120c is in direct contact with the third component 140c. In other words, the respective further layer portions 120a,b,c are attached to the respective components 140a,b,c. Optionally, a component and the respective further layer portion may be provided such in the respective cavity, that the further layer portion is in direct contact with the temporary carrier structure and the component is in direct contact with the opposed side of the further layer portion in regard to the contact side of the further layer portion with the temporary carrier structure (not shown). Additionally or alternatively, the first further portion 120a may be free from direct contact with the second further layer portion 120b and/or the second component 140b and/or the third further layer portion 120c and/or the third component 140c. Further additionally or alternatively, the second further portion 120b may be free from direct contact with the first further layer portion 120a and/or the first component 140a and/or the third further layer portion 120c and/or the third component 140c. Further additionally or alternatively, the third further portion 120c may be free from direct contact with the first further layer portion 120a and/or the first component 140a and/or the second further layer portion 120b and/or the second component 140b. The combined heights of the first component 140a and the first further layer portion 120a are the same as the combined heights of the second component 140b and the second further layer portion 120b and/or the combined heights of the third component 140c and the third further layer portion 120c. Additionally or alternatively, the combined heights of the first component 140a and the first further layer portion 120a may be different than the combined heights of the second component 140b and the second further layer portion 120b and/or the combined heights of the third component 140c and the third further layer portion 120c. Preferably, the respective further layer portions may be free from direct contact with the temporary carrier structure 190 and/or may be located at the opposed main surface of the respective components 140, which is in direct contact with the temporary carrier 190 in regard to stacking direction Z.

Figure 7 shows an exploded cross-sectional view of a component carrier 100 according to another exemplary embodiment of the present invention. Additionally to Figure 6, Figure 7 comprises a further electrically insulating layer structure 102. The further electrically insulating layer structure 102' is located next to the main surface of the stack 110 opposed to the main surface of the stack 110 which is in direct contact with the temporary carrier structure 190 in regard to stacking direction Z. Preferably, the stack 110 may be enlarged by the further electrically insulating layer structure 102'. The further electrically insulating layer structure 102' may comprise material being the same as the material from the electrically insulating layer structure(s) 102 and or the material of the further layer portions 120. Additionally or alternatively, the further electrically insulating layer structure 102' may comprise material being different from the material from the electrically insulating layer structure(s) 102 and or the material of the further layer portions 120. Optionally, the further electrically insulating layer structure 102' may be an exposed layer of a further stack.

Figure 8 shows a cross-sectional view of a component carrier 100 according to another exemplary embodiment of the present invention. In addition to Figure 7, the further electrically insulating layer structure 102' is in direct contact with the stack 110 and/or the further layer portions 120. This may be achieved by the application of elevated temperatures, for example larger than 70 °C, and/or elevated pressure, for example larger than 1.5 bar. Additionally, the space between the cavity 130 and components 140a,b,c and/or the at least one further layer portion 120a,b,c is filled by resin 150 flowed from one of the plurality of electrically insulating layer structures and/or from the at least one further layer portion and/or in particular from the further electrically insulating layer structure 102'. In the context of the present application the term "resin flowed from one of the plurality of electrically insulating layer structures and/or from the at least one further layer portion" has the reference number 150. Preferably, at least one component 140, in particular the first component 140a and/or the second component 140b and/or the third component 140c, may be at least partially embedded by resin 150 flowed from one of the plurality of electrically insulating layer structures and/or from the further layer portion. Additionally, the temporary carrier structure 190 is removed. Another electrically insulating layer structure 102" is provided to the stack 110, where the temporary carrier structure 190 was located before. The stack 110 may be increased by the other electrically insulating layer structure 102". In an example, the other electrically insulating layer structure 102" may be in direct contact with the components 140 and/or the at least one electrically conductive layer structure 104 and/or one of the plurality of the electrically insulating layer structures 102 and/or the resin 150 flowed from one of the plurality of electrically insulating layer structures and/or from the at least one further layer portion. Additionally or alternatively, the other electrically insulating layer structures 102" may be free from direct contact with the further layer portions 130a,b,c. One, in particular two, exposed main surfaces of the stack 110 may comprise electrically conductive layer structures 104. One exposed electrically conductive layer structure 104 may be (electrically) connected to one main surface of at least one component 140 and the other exposed electrically conductive layer structure 104 may be (electrically) connected to the other main surface of the same at least one component 140, in this example, the third component 140c. Additionally or alternatively, one exposed electrically conductive layer structure 104 may be (electrically) connected to one main surface of at least one component 140, in this example, the first component 140a. Preferably, the electrical connection of the different electrically conductive layer structures 104 and/or between an electrically conductive layer structure 104 and the respective component 140a,b,c may be achieved by a metal filled through connection, for example a via.

Figure 9 shows a microscopic image of a cross-sectional views of a component carrier 100 according to an exemplary embodiment of the present invention. The component carrier 100 is similar to the schematic drawing of Figure 8. The component carrier 100 comprises a stack 110 comprising a plurality of electrically conductive layer structures 104 and a plurality of electrically insulating layer structures 102. Additionally, the stack 110 comprises a cavity 130. In the cavity 130 three components 140a,b,c, in particular a first component 140a, a second component 140b and a third component 140c, are embedded. Additionally, a first further layer portion 120a, a second further layer portion 120b and a third further layer portion 120c, are partially filling the cavity 130. Two of the further layer portions are non-centred with respect to the cavity 130. Each of the further layer portions 120a,b,c comprises a respective plurality of further layer portions. As can be seen, each of the further layer portions 120a,b,c comprises glass fibers and/or cloth-woven fillers 160. Additionally or alternatively, the further layer portions 120a,b,c may comprise other filler particles, for example glass spheres. Each of the plurality of further layer portions 120a,b,c may comprise cut glass fibers 160. The extension of said cut glass fibers 160 may indicate the extension of each respective further layer portion 120 of each respective plurality of further layer portions. As can be seen, the glass fibers 160 are planarly shifted one to each other in regard to stacking direction Z, which also indicates that the corresponding further layer portions 120 are planarly shifted one to each other, see reference numbers 173, 174. In an example, at least two further (adjacent) layer portions 120 are non-planar one to each other. Preferably, between two adjacent further layer portions 120, in particular between two glass fibers 160, no electrically conductive layer structure 104 may be located. The profile defined by the stacked plurality of further layer portions 120a in a vertical cross section may be delimited by a virtual rectangular shape, see the dashed line indicating the first further layer portion 120a in Figure 9. Alternatively, the respective profile defined by the stacked plurality of further layer portions 120b,c in stacking vertical cross section may form a trapezoidal and/or rhombical and/or an irregular shape in cross-sectional view, see the dashed line indicating the second further layer portion 120b and/or the dashed line indicating the third further layer portion 120c in Figure 9. The different further layer portions 120 may have different heights h one to each other. Additionally, the amount of further layer portions 120a above the first components 140a may be different than the amount of further layer portions 120b above second component 140b and/or than the amount of further layer portions 120c above third component 140c. The respective further layer portions 120a,b,c may be misaligned one to each other. Each of the plurality of further layer portions composing the second further layer portion 120b has the same width in regard perpendicular to stacking direction Z. Since the plurality of further layer portions are planarly shifted one to each other in the same direction, the second further layer portion 120b has a profile shaped as a rhombus. Each of the plurality of further layer portions composing the third further layer portion 120c has different width in regard perpendicular to stacking direction Z. Since the plurality of further layer portions are planarly shifted one to each other in the same direction, the third further layer portion 120c has a profile shaped as a trapezoid. Additionally, the respective further layer portions 120a,b,c in respective cavity 130 may be misaligned one to each other; in particular at least two further layer portions 120a,b,c may be differently misaligned in the respective cavity 130; more in particular at least two further layer portions 120 may be misaligned in the respective cavity 130 along the same planar direction (not shown, compare with Figure 4). Preferably, at least one, in particular at least two, further layer portions 120a,b,c may comprise other filler particles, for example glass spheres and/or spheres comprising calcium oxide and/or barium sulfate. Further additionally or alternatively, the space between the first further layer portion 120a and the second further layer portion 120b is filled by resin 150 flowed from one of the plurality of the electrically insulating layer structures 102 and/or from the first further layer portion 120a and/or from the second further layer portion 120b. Further additionally or alternatively, the space between the first component 140a and the second component 140b is filled by resin 150 flowed from one of the plurality of the electrically insulating layer structures 102 and/or from the first further layer portion 120a and/or from the second further layer portion 120b.

As can be seen by Figure 9, the first further layer portion 120a and/or the second further layer portion 120b and/or the third further layer portion 120c are in (direct) contact with an electrically insulating layer structure 102, in particular the electrically insulating layer structure 102 closing the cavity 130 and/or the further electrically insulating layer structure 102'. Additionally, each respective further layer portion 120a,b,c in the cavity 130 is in (direct) contact with a layer structure composing the stack 110. In the shown Figure 9, the further layer portion of the respective one of the plurality of further layer portions which is located farthest away from the component 140a,b,c in regard to stacking direction Z, in particular the top further layer portion, is in contact with the further electrically insulating layer structure 102'. Preferably, between the top further layer portion and the further electrically insulating layer structure 102' composing the stack 110 no electrically conductive layer structure 104 may be located. Preferably, the further layer portion 120 may comprise a thermal insulating material, for example an epoxy resin. Additionally or alternatively, the further layer portion 120 may comprise a thermal conductive material (not shown).

Figure 10 illustrate a microscopic image of a cross-sectional views of a component carrier 100 according to a further exemplary embodiment of the present invention. In particular, the Figure 10 is a magnification of the left part of Figure 9. Figure 10 illustrates to resin flow 150 of the further layer portion 120. The resin 150 of the further layer portion 120 located adjacent to the component 140 flows due to for example temperatures higher than 70 °C towards, in particular into, the space between the cavity 130 and the component 140. Additionally, resin 150 of other further layer portions 120, in particular which are stacked above the further layer portion 120 located adjacent to the component 140, may flow towards, in particular into, the space between the cavity 130 and the component 140. This is indicated by the arrows in Figure 10. Additionally or alternatively, another resin 150' originated from the electrically insulating layer structure 102, in particular the further electrically insulating layer structure 102', flows into the space between the cavity 130 and the further layer portions 120. Thereby an interface between the resin 150 flowed from the further layer portions 120 and the other resin 150' flowed from the further electrically insulating layer structure 102' is formed, which is indicated by the dashed line in Figure 10. Additionally or alternatively, the resin 150 flowed from the further layer portions 120 and the other resin 150' flowed from the further electrically insulating layer structure 102' may mix and/or intermingle with each other. Due the complex flow behavior of the resin 150 during manufacturing of the component carrier 100, filler particles, in particular glass spheres 160, are randomly distributed in the further layer portion and/or in the space between the cavity 130 and the component 140 and/or in the space between the cavity 130 and the further layer portion 120. In an example, at least two further layer portions 120 may comprise different kinds of filler particle material and/or filler particle composition and/or filler particle shape one to each other. Preferably, the explained resin flow 150 may be applicable to Figure 4 and/or Figure 8. Preferably, the space between the cavity 130 and the first further layer portion 120a may be filled by resin 150 flowed from the first further layer portion 120a and/or other resin 150' flowed from one of the plurality of the electrically insulating layer structures 102 and/or further electrically insulating layer structure 102'. Additionally or alternatively, the space between the cavity 130 and the first component 140a may be filled by resin 150 flowed from the first further layer portion 120a and/or other resin 150' flowed from one of the plurality of the electrically insulating layer structures 102 and/or further electrically insulating layer structure 102'. The flowed resin at least partially encapsulates the component 140. In particular, the flowed resin 150 at least partially encapsulating the components 140 is provided between the cavity wall and the component 140. Additionally, the flowed resin 150 is in direct contact with at least one main surface of the components 140. The cavity 130 is closed at the top extremity and/or the bottom extremity of the cavity by at least one electrically insulating layer structure 102, in particular the further electrically insulating layer structure 102' and the other electrically insulating layer structure 102". This can be seen by the non-disrupted glass fibers 160 which are belonging to the adjacent electrically insulating layer structures 102, in particular the further electrically insulating layer structure 102' and the other electrically insulating layer structure 102", with respect to the cavity 130, wherein the electrically insulating layer structures 102 closing the cavity 130 comprise respective glass fibers 160. Preferably, the flowed resin 150 closing at least one vertical extremity of the cavity 130 flowed from one of electrically insulating layer structures 102, in particular the further electrically insulating layer structure 102' and the other electrically insulating layer structure 102". The further electrically insulating layer structure 102' composing the stack 110 is deformed toward the component 140 at the area of the cavity 130. This deformation 170 can be seen by the curved, in particular concave, shape of the glass fibers 160, which are located in the further electrically insulating layer structure 102', as can be seen be the indicated dashed line. In other words, the further electrically insulating layer structure 102' composing the stack 110 comprises an embedded reinforcing structure 160, said reinforcing structure 160 being deformed toward the component 140 at the area of the cavity 130.

Figure 11 illustrate a microscopic image of a cross-sectional views of a component carrier 100 according to a further exemplary embodiment of the present invention. In particular, the Figure 11 is a magnification of the middle part of Figure 9. Figure 11 illustrates the resin flow 150 of the further layer portion 120. The resin 150 of the further layer portion 120 located adjacent to the component 140 flows due to for example temperatures higher than 70 °C towards, in particular into, the space between two adjacent components 140 indicated by the arrow in Figure 11. Additionally, resin 150 of other further layer portions 120, in particular which are stacked above the further layer portion 120 located adjacent to the component 140, may flow towards, in particular into, the space between two adjacent components 140 and/or into the space between two laterally adjacent further layer portions 120. Additionally or alternatively, another resin 150' originated from the further electrically insulating layer structure 102' flows into the space between two laterally adjacent further layer portions 120.

Thereby an interface between the resin 150 flowed from the further layer portions 120 and the other resin 150' flowed from the further electrically insulating layer structure 102' is formed and/or an interface between the resin 150 flowed from the further layer portions 120 and the resin 150 from another further layer portion 120 is formed, which is indicated by the dashed line in Figure 11. Preferably, the explained resin flow 150 may be applicable to Figure 4 and/or Figure 8. Additionally, as can be seen by Figure 11, the opposed two main surface of the respective components 140 are provided at different vertical levels in regard to stacking direction Z. In particular, the top main surfaces of the respective components 140 and/or the bottom main surfaces of the respective components 140 are provided at different vertical levels in regard to stacking direction Z. Further additionally, the glass fibers 160 of the other electrically insulating layer structure 102" may have at least partially a different elongation direction in regard to one main surface of the adjacent component 140. In other words, at least a portion of the elongation direction of the glass fibers 160 may be inclined in regard to the main surface of at least one component 140. Additionally, the stack 110 comprises an exposed electrically conductive layer structures 104, which is in direct contact with the further electrically insulating layer structure 102'. The exposed electrically conductive layer structure 104 may also comprise the deformation 170. In an example, the deformation 170 may comprise a dimple. Preferably, the deformation 170, in particular deformation of the further electrically insulating layer structure 102' composing the stack 110, may contribute to the contact of the further layer portion 120 with the component 140.

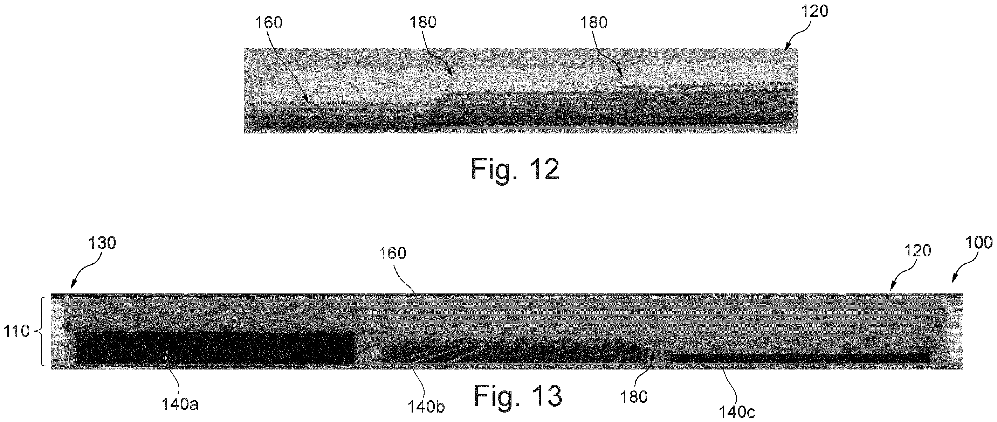

Figure 12 illustrates an image of a further layer portion 120 according to an exemplary embodiment of the present invention. The further layer portion 120 is composed of a plurality of layers. In particular, at least one layer, in particular the plurality of layers, comprises electrically insulating material and glass fibers 160. In the shown example, the plurality of layers is made of prepreg material. The plurality of layers is provided such, that the respective layers are stacked one above each other in regard to stacking direction Z. The further layer portion 120 comprises two stepped portions 180. Optionally, the further layer portion 120 may comprise a copper body and/or a glass body and/or a core structure (not shown). Preferably, the stepped portion 180 may be created due the fact that two adjacent layers of the further layer portion 120 have different lateral extensions. The combined outer contour of the two adjacent layers of the further layer portion may create the stepped portion 180.

Figure 13 shows a microscopic image of a cross-sectional views of a component carrier 100 according to an exemplary embodiment of the present invention. Compared to Figure 9, the stack component carrier 100 comprises only one further layer portion 120. In particular, the further layer portion 120 has the structure as shown in Figure 12. The further layer portion 120 has a larger planar extension than that of the main surface of the embedded component 140. In particular, the at least one further layer portion 120 has a larger planar extension than the sum of the main surface of the three embedded components 140. The stepped portion 180 of the further layer portion 120 can be seen by the cut glass fibers 160. In the shown example, the further layer portion 120 fills at least 70% of the cavity 130. The components 140 and the further layer portion 120 occupy at least 90% of the cavity 130, which results in an easy and reliable fully filling of the cavity with the resin 150 resin flowed from one of the plurality of electrically insulating layer structures 102 and/or from the at least one further layer portion 120. This can be especially beneficial when a cavity with a volume larger than 1 mm³, in particular larger than 10 mm³, has to be fully filled. As can be seen in Figure 13, the at least a portion of at least one glass fibers 160 may have an elongation non-parallel to the main extension direction of the component carrier 100 or perpendicular to stacking direction Z. The further layer portion 120 comprises five layers of electrically insulating material comprising glass fibers 160, for example prepreg, stacked one above the other adjacent to the first component 140a and/or comprises six layers of electrically insulating material comprising glass fibers 160, for example prepreg, stacked one above the other adjacent to the second component 140b and/or seven layers of electrically insulating material comprising glass fibers 160, for example prepreg, stacked one above the other adjacent to the third component 140c in regard to stacking direction Z.

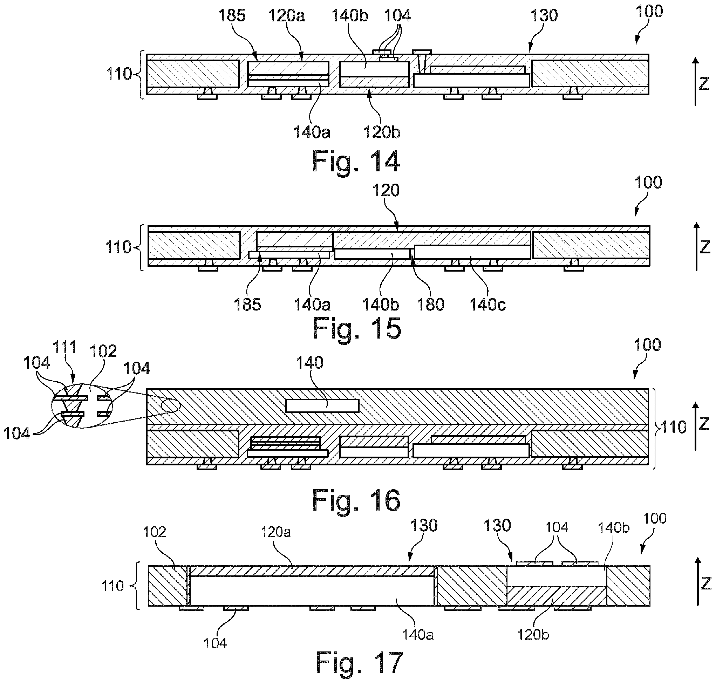

Figure 14 shows a cross-sectional view of a component carrier 100 according to an exemplary embodiment of the present invention. The component carrier 100 is similar to the component carrier shown in Figure 4. The component carrier 100 shown in Figure 14 comprises a first further layer portion 120a in direct contact with the first component 140a. In this example, the first further layer portion 120a comprises at least one thermally conductive material 185. In an example, the thermally conductive material 185 may comprise a thermally conductive electrically insulating material, for example a ceramic material and/or a thermally conductive organic polymeric material. Additionally or alternatively, the thermally conductive material 185 may comprise thermally conductive and electrically conductive material, for example a metal, in particular copper. Preferably, the thermally conductive and electrically conductive material may be in direct contact with the first component 140a. The thermally conductive material 185 may comprise resin material, in particular the resin material of the thermally conductive material 185 may fill the space between the cavity 130 and the first component 140a. Additionally or alternatively, the thermally conductive material 185 may fill the space between the cavity 130 and the first further layer portion 120a and/or the space between the first component 140a and the second component 140b and/or the space between the first further layer portion 120a and the second further layer portion 120b. As can be seen by Figure 14, the second further layer portion 120b is laterally provided on the same vertical level next to the first component 140a and/or the third component 140c in regard to stacking direction Z. Additionally or alternatively, the second component 120b is laterally provided on the same vertical level next to the first further layer portion 120a and/or the third further layer portion 120c in regard to stacking direction Z.

Figure 15 shows a cross-sectional view of a component carrier 100 according to an exemplary embodiment of the present invention. The component carrier 100 is similar to the component carrier shown in Figure 13. In comparison to Figure 13, the shown component carrier 100 in Figure 15 comprises a further layer portion 120 having a lateral extension being smaller than the sum of the width w of the first component 140a, the second component 140b and the third component 140c. Additionally, the further layer portion 120 is divided into at least two portions. One of the at least two portions of the further layer portion 120 comprises a thermally conductive material 185. Further additionally the further layer portion 120 comprises a stepped portion 180.

Figure 16 shows a cross-sectional view of a component carrier 100 according to an exemplary embodiment of the present invention. The component carrier 100 is similar to the component carrier shown in Figure 8. In addition to Figure 8, the component carrier of Figure 15 comprises additional electrically insulating layer structures 102 and electrically conductive layer structures 104, as can be seen by the magnification 111. In the additionally electrically insulating layer structures 102 a further component 140 is embedded.

Figure 17 shows a cross-sectional view of a component carrier 100 according to an exemplary embodiment of the present invention. The component carrier 100 comprises a stack 110 comprising one electrically insulating layer structure 102 and two electrically conductive layer structures 104. Additionally or alternatively the stack 110 may comprise a plurality of electrically insulating layer structure 102 and a plurality of electrically conductive layer structures 104 as shown in Figure 4. The stack 110 comprises two cavities 130 each cavity 130 comprising a respective component 140a, 140b and a respective further layer portion 120a, 120b. In comparison to Figure 4, Figure 17 is free from a further layer structure closing the vertical extremities of the respective cavity 130. The first further layer portion 120a is exposed on one surface of the stack 110 and the first component 140a is exposed on the other opposed surface of the stack 110. The same situation is valid for the second further layer portion 120b and the second component 140b with the difference that they are flipped upside down in comparison to the first further layer portion 120a and the first component 140a. The electrically conductive layer structure 104 is in direct contact with the respective components 140a, 140b.

It should be noted that the term "comprising" does not exclude other elements or steps and the "a" or "an" does not exclude a plurality. Also, elements described in association with different embodiments may be combined.

Implementation of the invention is not limited to the preferred embodiments shown in the figures and described above. Instead, a multiplicity of variants is possible which use the solutions shown and the principle according to the invention, whose scope is defined by the appended claims.

### List of Reference Signs

- 100: component carrier
- 102: electrically insulating layer structure
- 104: electrically conductive layer structure
- 110: stack
- 111: magnification
- 120a,b,c: further layer portions
- 130, 130a,b,c: cavities
- 140a,b,c: components
- 150: resin flowed from one of the plurality of electrically insulating layer structures and/or from the at least one further layer portion
- 160: fillers
- 170: deformation
- 180: stepped portion
- 185: thermally conductive material
- 190: temporary carrier structure

- h1, h2, h3: height (of the component)
- w1, w2, w3: width (of the component)
- Z: thickness direction

## Claims

1. A component carrier (100), which comprise:
a stack (110) comprising at least one electrically conductive layer structure (104) and a plurality electrically insulating layer structures (102),
said stack (110) comprising a cavity (130);
a component (140) embedded in the cavity (130);
at least one further layer portion (120) partially filling the cavity (130),
wherein the space between the cavity (130) and component (140) and/or the at least one further layer portion (120) is filled by resin (150) flowed from one of the plurality of electrically insulating layer structures and/or from the at least one further layer portion.

2. A component carrier (100) according to claims 1,
wherein the at least one further layer portion (120) is non-centred/non-planar with respect to the cavity (130).

3. A component carrier (100) according to one of the claims 1 to 2,
wherein the at least of further layer portion (130) comprises a stepped portion (180) in regard to a cross-sectional view and/or a top view.

4. A component carrier (100) according to one of the claims 1 to 3,
wherein the component carrier (100) comprises at least two further layer portions (120) partially filling the cavity,
in particular wherein the at least two further layer (120) portions are planarly shifted one to each other; and/or
in particular wherein the at least two further layer portions (120) are non-planar one to each other.

5. A component carrier (100) according to 4,
wherein between two adjacent further layer portions (120) no electrically conductive layer structure (104) is located.

6. A component carrier (100) according to one of the claims 1 to 5,
wherein the at least one further layer portion (120) has a different, in particular a smaller, planar extension than that of the main surface of the embedded component (140).

7. A component carrier (100) according to one of the claims 1 to 6,
wherein a plurality of components (140) is embedded in the cavity (130), in particular wherein at least two of the plurality of components (140) have a different height h one to each other; and/or in particular wherein the amount of further layer portions (120) above one of the at least two components (140) is different than the amount of further layer portions (120) above the other one of the at least two components (140).

8. A component carrier (100) according to one of the claims 1 to 7,
wherein said at least two components (140) are provided in the cavity (130).

9. A component carrier (100) according to one of the claims 1 to 8,
wherein the stack (110) comprises a plurality of cavities (130).

10. A component carrier (100) according to claim 9,
wherein a first cavity of said plurality of cavities comprises a component with a first height, a second cavity of said plurality of cavities comprises a component with a second height and the heights of the respective components are different one to each other; and/or
wherein one and/or the first cavity of said plurality of cavities is partially filled by a different amount of further layer portions compared with those in a further one and/or the second cavity of said plurality of cavities; and/or
wherein the further layer portions in the respective cavities are misaligned one to each other.

11. A component carrier (100) according to one of the claims 1 to 10, wherein the at least one of the further layer portions comprises fillers (160), in particular filler particles,
more in particular wherein at least two further layer portions (120) comprise different kinds of filler material and/or filler composition and/or filler shape one to each other; and/or
wherein the fillers (160) comprise cloth-woven fillers.

12. A component carrier (100) according to one of the claims 1 to 11,
wherein the at least one further layer portion (120) in the cavity (130) is in contact with the at least one layer structure (102, 104) composing the stack (110).

13. A component carrier (100) according to one of the claims 1 to 12,
wherein the at least one layer structure (102, 104) composing the stack (110) is deformed toward the component (140) at the area of the cavity (130),
in particular wherein the deformation (170) comprises a dimple of the at least one layer structure (102, 104) composing the stack (110) toward the component (140).

14. A component carrier (100) according to one of the claims 1 to 13,
wherein the at least one further layer portion (120) is attached to the component (140),
in particular wherein the at least one further layer portion (120) comprises a dummy component.

15. A method of manufacturing a component carrier (100), wherein the method comprises:
providing a stack (110) comprising at least one electrically conductive layer structure (104) and a plurality electrically insulating layer structures (102);
providing a cavity (130) in the stack (110) ;
providing a component (140) in the cavity (130) ;
providing at least one further layer portion (120) in the cavity (130);
filling the space between the cavity (130) and component (140) and/or the at least one further layer portion (120) by resin (150) flowed from one of the plurality of electrically insulating layer structures and/or from the at least one further layer portion.
